Europäisches Patentamt

European Patent Office

Office européen des brevets

(19)

(11) Veröffentlichungsnummer: **0 326 935 B1**

## (12) EUROPÄISCHE PATENTSCHRIFT

(45) Veröffentlichungstag der Patentschrift: **20.10.93**

(51) Int. Cl.5: **C23C 14/06**, G11B 11/10

(21) Anmeldenummer: **89101311.2**

(22) Anmeldetag: **26.01.89**

(54) **Verfahren zur Herstellung einer dünnen röntgenamorphen Aluminiumnitrid- oder Aluminium-siliciumnitridschicht auf einer Oberfläche.**

(30) Priorität: **02.02.88 DE 3802998**

(43) Veröffentlichungstag der Anmeldung:
**09.08.89 Patentblatt 89/32**

(45) Bekanntmachung des Hinweises auf die
Patenterteilung:
**20.10.93 Patentblatt 93/42**

(84) Benannte Vertragsstaaten:
**DE FR GB NL**

(56) Entgegenhaltungen:
**EP-A- 0 216 634
EP-A- 0 233 062
US-A- 4 719 154**

**JOURNAL OF VACUUM SCIENCE & TECHNO-
LOGY A, Band 5, Nr. 4, Teil III, Juli/August
1987, Seiten 1630-1634, Second Series, Woodbury, US; F.S. OHUCHI et al.: "AlN thin
films with controlled crystallographic orientations and their microstructure"**

(73) Patentinhaber: **BASF Aktiengesellschaft
Carl-Bosch-Strasse 38
D-67063 Ludwigshafen(DE)**

(72) Erfinder: **Steininger, Helmut, Dr.
Dr.-Ernst-Kilb-Weg 15
D-6520 Worms 26(DE)**

JOURNAL OF VACUUM SCIENCE & TECHNO-
LOGY A, Band 3, Nr. 3, Teil II, Mai/Juni 1985,
Seiten 1201-1203, New York, US; S.G. NOYES
et al.: "Aluminum/aluminum-nitride sputter
deposition on the inertial fusion target using
the pulsed-gas process"

JAPANESE JOURNAL OF APPLIED PHYSICS,
Band 20, Nr. 3, März 1981, Seiten L169-L172,
Tokyo, JP; F. TAKEDA et al.: "Effect of hydrogen gas on c-axis oriented AIN films prepared by reactive magnetron sputtering"

JAPANESE JOURNAL OF APPLIED PHYSICS,
Band 22, Nr. 3, Teil I, März 1983, Seiten
L418-L422, Tokyo, JP; K. TOMINAGA et al.:
"High-energy particles in AIN film preparation by reactive sputtering technique"

IEEE TRANSACTIONS ON MAGNETICS, Band
MAG-22, Nr. 5, September 1986, Seite 946,
New York, US; T.K. HATWAR et al.:
"Corrosion-resistant protective overcoat for
magnetooptical media"

**Beschreibung**

Die vorliegende Erfindung betrifft ein neues, verbessertes Verfahren zur Herstellung einer dünnen röntgenamorphen Aluminiumnitrid- oder Aluminiumsiliciumnitridschicht auf einer Oberfläche durch reaktive Kathodenzerstäubung oder reaktive Magnetronkathodenzerstäubung von Aluminium oder von Aluminium und Silicium im Vakuum in einer Edelgas und Stickstoff enthaltenden Prozeßgasatmosphäre und durch Abscheiden der betreffenden Nitridschicht aus der Gasphase.

Bei der reaktiven Kathodenzerstäubung ("reactive sputtering") wird bekanntermaßen das Material einer Kathode ("target") durch Beschuß mit Argonionen in die Gasphase überfuhrt, d.h. das Kathodenmaterial wird zerstäubt. Dem in dieser Weise resultierenden Prozeßgas werden reaktive gasförmige Komponenten, wie etwa Sauerstoff oder Stickstoff zugemischt, welche zusammen mit dem zerstäubten Kathodenmaterial auf der zu beschichtenden Oberfläche als dünne Oxid- oder Nitridschicht abgeschieden werden. Bei der reaktiven Magnetronkathodenzerstäubung ("reactive magnetron sputtering") befindet sich das "target" bekanntermaßen in einem Magnetfeld. Durch die Variation von Verfahrensparametern wie Zerstäubungs- und Abscheiderate sowie Prozeßgasdruck und -zusammensetzung können dünne Schichten unterschiedlicher Zusammensetzung und/oder unterschiedlicher Morphologie erzeugt werden.

Verfahren zur Herstellung dünner polykristalliner oder semiamorpher Aluminiumnitrid- oder röntgenamorpher Aluminiumsiliciumnitridschichten sind bekannt.

So geht aus der EP-A-0 233 062 ein Verfahren zur Herstellung einer dünnen röntgenamorphen Aluminiumsiliciumnitridschicht hervor, bei welchem man

(i) ein "target" aus $Si_{40}Al_{60}$ und als Prozeßgas Argon und Stickstoff im Volumenverhältnis von 1,5:1 oder

(ii) ein "target" aus $Si_{80}Al_{20}$ und als Prozeßgas Argon und Stickstoff im Volumenverhältnis von 4:1

verwendet.

Darüber hinaus ist

- aus dem Artikel von J.M. Lagorsse und B. Serzec in Proceedings of the Seventh International Vacuum Congress and 3rd International Conference on Solid Surfaces, Wien 1977, Seiten 1995 bis 1997, die Herstellung von Aluminiumnitridschichten durch reaktive Kathodenzerstäubung von Aluminium in Stickstoff oder in Stickstoff und Wasserstoff als Prozeßgas.

- aus dem Artikel von F. Takeda, T. Mori und T. Takahashi in Japanese Journal of Applied Physics, Band 20, Nummer 3, März 1981, Seiten L164 bis L172, die Herstellung von Aluminiumnitridschichten durch reaktive Magnetronkathodenzerstäubung von Aluminium in Stickstoff oder in Stickstoff und Wasserstoff als Prozeßgas,

- aus dem Artikel von Li Xinjiao, Xu Zechuan, He Ziyou, Cao Huazhe, Su Wuda, Chen Zhongcai, Zhou Feng und Wang Enguang in Thin Solid Films, Band 139, 1986, Seiten 261 bis 274 die Herstellung von Aluminiumnitridschichten durch Hochfrequenzkathodenzerstäubung von Aluminium in einem Gemisch aus Argon und Stickstoff im Volumenverhältnis von 1:1 als Prozeßgas,

- aus dem Artikel von S. Bhat, S. Ashok, S.J. Fonash und L. Tongson in Journal of Electronic Materials, Band 14, Nummer 4, 1985, Seiten 405 bis 418, die Herstellung von Aluminiumnitridschichten durch reaktive Ionenstrahlzerstäubung ("reactive ion beam sputtering") in einem Gemisch aus Stickstoff und Wasserstoff und

- aus dem Artikel von C.R. Aita und C.J. Gawlak in Journal of Vacuum Science and Technology, B and A1, Nummer 2, April-Juni 1983, Seiten 403 bis 406, die Herstellung von semiamorphen Aluminiumnitridschichten durch Hochfrequenzkathodenzerstäubung in einem Gemisch aus Argon und Stickstoff wechselnder Zusammensetzung als Prozeßgas

bekannt.

In der US-A-4719154 ist ein Verfahren zur Herstellung röntgenamorpher AlN-Schichten für magneto-optische Aufzeichnungsmedien beschrieben, bei dem die Schicht durch reaktive Kathodenzerstäubung in einer Atmosphäre aus $N_2$ und Ar abgeschieden wird. Durch eine genaue Kontrolle des Stickstoff-Argon-Verhältnisses wird sichergestellt, daß die resultierende Schicht aus AlN amorph ist.

In dem Artikel "AlN thin films with controlled crystallographic orientations and their microstructure" von Ohuchi und Russel im Journal of Vacuum Science and Technology, Band A5(4), 1987, Seiten 1630-1634, wird die Abscheidung von dünnen Aluminiumnitridfilmen mit unterschiedlicher Morphologie mittels reaktiver RF-Zerstäubung beschrieben. Die Morphologie wird durch die RF-Leistung und die Zusammensetzung der Stickstoff/Edelgas-Mischung kontrolliert. Die Verwendung von Neon, Krypton und Xenon mit Stickstoff anstelle von Argon/Stickstoff-Mischungen ändert bei ansonsten unveränderten Zerstäubungsparametern die Zerstäubungsrate. Eine amorphe Aluminiumnitridschicht wird nur erhalten, wenn als Edelgaskomponente Xenon verwendet wird.

Darüber hinaus geht aus dem Beispiel 1 der DE-A-35 00 314 ein Verfahren zur Herstellung einer Schicht aus einem Gemisch von Siliciumnitrid und Siliciumoxid durch reaktives Aufdampfen von Silicium in einem Gemisch aus Stickstoff, Sauerstoff und Argon mit dem Volumenverhältnis von 2:1:7 als Prozeßgas hervor. Aus dem Beispiel 2 der DE-A-35 00 314 ist außerdem ein Verfahren zur Herstellung einer Schicht aus einem Gemisch von Aluminiumnitrid und Aluminiumoxid durch reaktives Zerstäuben von Aluminium in einem Gemisch aus Stickstoff, Sauerstoff und Argon mit dem Volumenverhältnis von 2,5:0,5:7,0 bekannt. Es geht aus der DE-A-35 00 314 nicht hervor, ob diese Schichten röntgenamorph anfallen oder ob sie polykristallin sind, d.h., ob sie beim Bestrahlen mit Röntgenstrahlen keine Beugungsbilder mehr liefern oder ob sie aus Kristalliten bestehen, deren Größe im Nanometerbereich liegt.

Die bislang bekannten Verfahren zur Herstellung dünner Aluminiumnitrid- oder Aluminiumsiliciumnitridschichten weisen Nachteile auf.

So sind die bekannten Verfahren zur Herstellung dünner röntgenamorpher Aluminiumnitrid- und Aluminiumsiliciumnitridschichten relativ kompliziert und erfordern die Einhaltung zahlreicher Parameter.

Es ist nun aus vielen Bereichen der Technik bekannt, daß röntgenamorphe Schichten ganz allgemein einen besseren Korrosionsschutz bieten, als polykristalline, weil in den röntgenamorphen Schichten die Korngrenzdiffusion korrosiver Stoffe und/oder die Zerstörung der Schichten via Korngrenzkorrosion nicht auftritt. Es besteht daher allgemein ein großer Bedarf an Verfahren, mit deren Hilfe sich röntgenamorphe Schichten in einfacher und zuverlässiger Weise herstellen lassen.

Dieser Bedarf konnte bislang im Falle von Aluminiumnitrid- und Aluminiumsiliciumnitridschichten nicht in der von der Praxis geforderten Weise gedeckt werden. Dies stellt insbesondere bei der Anwendung der bekannten Verfahren im Rahmen der Herstellung flächenförmiger, mehrschichtiger magneto-optischer Aufzeichnungsmaterialien einen besonders schwerwiegenden Nachteil dar. Denn gerade auf diesem technischen Gebiet ist der zuverlässige und lang anhaltende Schutz der höchst luft- und wasserempfindlichen magneto-optischen Aufzeichnungsschichten (B) vor Korrosion ein vordringliches Problem, welches indes durch die nach den bekannten Verfahren erzeugten Aluminiumnitrid- oder Aluminiumsiliciumnitridschichten noch nicht zur Gänze gelöst werden konnte.

Aufgabe der vorliegenden Erfindung ist es, ein neues, verbessertes Verfahren zur Herstellung einer dünnen röntgenamorphen Aluminiumnitrid- oder Aluminiumsiliciumnitridschicht auf einer Oberfläche zu finden, bei welchem man Aluminium oder Aluminium und Silicium im Vakuum in einer Edelgas und Stickstoff enthaltenden Prozeßgasatmosphäre der reaktiven Kathodenzerstäubung oder der reaktiven Magnetronkathodenzerstäubung unterwirft und welches die Nachteile des Standes der Technik nicht mehr länger aufweist, sondern welches in zuverlässiger und einfacher Weise dünne röntgenamorphe Aluminiumnitrid- und Aluminiumsiliciumnitridschichten liefert, die ein vorzügliches Eigenschaftsprofil aufweisen.

Demgemäß wurde ein Verfahren zur Herstellung einer dünnen röntgenamorphen Aluminiumnitrid- oder Aluminiumsiliciumnitridschicht auf einer Oberfläche durch reaktive Kathodenzerstäubung oder reaktive Magnetronkathodenzerstäubung von Aluminium oder von Aluminium und Silicium im Vakuum in einer Edelgas und Stickstoff enthaltenden Prozeßgasatmosphäre und durch Abscheiden der betreffenden Nitridschicht aus der Gasphase gefunden, welches dadurch gekennzeichnet ist, daß man hierbei

(a) als Edelgas ein Gemisch von Argon und einem oder mehreren der Edelgase Neon, Krypton oder Xenon verwendet, wobei

(b) das Volumenverhältnis von Argon zu den anderen Edelgasen bei 2:1 bis 100:1 liegt und wobei

(c) das Volumenverhältnis des Edelgasgemischs (a) zu Stickstoff bei 2:1 bis 10:1 liegt.

Im folgenden wird das Verfahren zur Herstellung einer dünnen röntgenamorphen Aluminiumnitrid- oder Aluminiumsiliciumnitridschicht auf einer Oberfläche der Kürze halber als "erfindungsgemäßes Verfahren" bezeichnet.

Das erfindungsgemäße Verfahren weist apparativ keine Besonderheiten auf, sondern es wird in den üblichen und bekannten Anlagen für die reaktive (Magnetron)Kathodenzerstäubung durchgeführt. Diese Anlagen bestehen im wesentlichen aus mindestens einer Hochvakuumkammer, welche die üblichen und bekannten

- Schleusen zum Ein- und Ausbringen der zu beschichtenden bzw. der beschichteten Materialien,
- Vorrichtungen zum Drehen der zu beschichtenden Materialien,
- Anschlüsse an elektrische Strom- und Spannungsquellen,
- Heiz- und Kühleinrichtungen,
- Kathoden und Anoden der geeigneten Form,
- gegebenenfalls starke Magnete,
- geeignete Energiequellen für das Erzeugen von Ionen,
- Einrichtungen für die Zufuhr der Prozeßgase,

- Vakuumanschlüsse sowie
- die entsprechenden üblichen und bekannten elektronischen und mechanischen Meß- und Regeleinrichtungen

aufweist.

In diese Anlagen werden "targets" eingebracht und auf der Kathode plaziert. Bei den "targets" handelt es sich üblicherweise um Scheiben oder Platten aus Aluminium oder aus Aluminium und Silicium oder aus Aluminium-Silicium-Legierungen.

Die zu beschichtenden Materialien werden gleichfalls in die Anlagen eingebracht. Die Materialien können von unterschiedlichster Form und Zusammensetzung sein. So können beispielsweise Silicium- oder andere Halbleiter-Plättchen ("wafer"), Glas, Polymerfilme, Metallschichten, Farbstoffschichten usw. verwendet werden.

Nach dem Einbringen der "targets" und der zu beschichtenden Materialien werden die Anlagen evakuiert ($10^{-5}$ bis $10^{-6}$ mbar). Gegebenenfalls schließt sich hieran eine Vorbehandlung der "targets" und der zu beschichtenden Oberfläche der Materialien an, wie etwa ein Vorzerstäuben und Abscheiden von Aluminium und/oder Silicium auf der betreffenden Oberfläche in der Gegenwart von Argon.

Nach dieser Vorbereitung der (Magnetron)Kathodenzerstäubungsanlage wird das erfindungsgemäße Verfahren durchgeführt.

Bei dem erfindungsgemäßen Verfahren wird das Aluminium- oder das Aluminiumsilicium-"target" zerstäubt. Hierbei enthält die Prozeßgasatmosphäre ein Gemisch aus Edelgasen und Stickstoff, wobei man als Edelgase ein Gemisch (a) aus Argon und einem oder mehreren der Edelgase Neon, Krypton oder Xenon verwendet.

Erfindungsgemäß liegt hierbei das Volumenverhältnis (b) von Argon zu den anderen Edelgasen bei 2:1 bis 100:1, weil innerhalb dieses Bereichs zuverlässig und sicher vorteilhafte, dünne röntgenamorphe Aluminiumnitrid- und Siliciumnitridschichten abgeschieden werden. Im allgemeinen erübrigt es sich, das Volumenverhältnis (b) von Argon zu den anderen Edelgasen kleiner als 2:1 zu wählen, d.h. vergleichsweise mehr der Edelgase Neon, Krypton oder Xenon zu verwenden, weil hierdurch nur noch eine vergleichsweise geringe Steigerung des ohnedies schon ausgezeichneten Verfahrenserfolges - sprich dünne röntgenamorphe Aluminiumnitrid- oder Aluminiumsiliciumnitridschichten - erzielt wird. Andererseits soll das Volumenverhältnis (b) 100:1 nicht überschreiten, weil sich dann des öfteren polykristalline oder semiamorphe Schichten anstelle der gewünschten röntgenamorphen abscheiden. Erfindungsgemäß von Vorteil sind Volumenverhältnisse (b) zwischen 3:1 und 80:1, vorzugsweise 3,5:1 und 50:1, insbesondere 4:1 und 30:1, wobei die Volumenverhältnisse (b) zwischen 4:1 und 30:1 hervorzuheben sind, weil bei der Verwendung dieser Volumenverhältnisse (b) besonders vorteilhafte Aluminiumnitrid- und Aluminiumsiliciumnitridschichten erhalten werden. Innerhalb dieses Bereiches können deshalb die Volumenverhältnisse (b) mit Vorteil variiert und den übrigen Verfahrensparametern angepaßt werden.

Erfindungsgemäß liegt das Volumenverhältnis (c) des Edelgasgemisches (a) zu Stickstoff bei 2:1 bis 10:1. Bei der Verwendung von Volumenverhältnissen (c) innerhalb dieses Bereichs werden vorteilhafte, dünne röntgenamorphe Aluminiumnitrid- und Siliciumnitridschichten erhalten. Es empfiehlt sich nicht, Volumenverhältnisse (c) von kleiner als 2:1, d.h. vergleichsweise größere Stickstoffmengen, anzuwenden, weil hierdurch oftmals polykristalline oder semiamorphe Schichten anstelle der gewünschten amorphen Schichten resultieren und die Abscheideraten der Nitridschichten so weit abgesenkt werden, daß sie den Anforderungen der betrieblichen Praxis nicht mehr genügen, sondern nur noch in speziellen Fällen vertretbar sind. Andererseits soll das Volumenverhältnis (c) den Wert von 10:1 nicht überschreiten, weil hierbei einerseits nur noch eine vergleichsweise geringe Steigerung des Verfahrenserfolgs resultiert und andererseits die abgeschiedenen Schichten zu wenig Stickstoff enthalten. Erfindungsgemäß von Vorteil ist ein Volumenverhältnis zwischen 3,5:1 und 6,5:1, wobei der Bereich von 4:1 bis 6:1 von besonderem Vorteil ist, weil innerhalb dessen das Volumenverhältnis (c) mit besonderem Vorteil variiert und den übrigen Verfahrensparametern angepaßt werden kann.

Bekanntermaßen werden bei der (Magnetron)Kathodenzerstäubung Abscheideraten von etwa 0,5 bis 2 $nm \cdot s^{-1}$ angewandt. Diese Abscheideraten sind auch im Falle des erfindungsgemäßen Verfahrens geeignet.

Bekanntermaßen liegt die Kathodenleistung P bei der (Magnetron)Kathodenzerstäubung bei P = 0,1 bis 10 kW, vorzugsweise 0,5 bis 8, vorteilhafterweise 0,6 bis 5 und insbesondere 0,8 bis 2,5 kW. Diese Kathodenleistung P wird auch bei dem erfindungsgemäßen Verfahren angewandt.

Üblicherweise steht die Prozeßgasatmosphäre bei der (Magnetron)Kathodenzerstäubung unter einem sehr niedrigen Druck. Dieser Druck liegt im allgemeinen bei insgesamt $10^{-4}$ bis $5 \cdot 10^{-3}$ mbar, d.h., die Prozeßgasatmosphäre ist im üblichen Sinne ein Vakuum, dessen Restgaszusammensetzung allerdings sehr exakt eingestellt wird. Auch bei dem erfindungsgemäßen Verfahren steht die erfindungsgemäß zu verwendende Prozeßgasatmosphäre unter diesem Druck.

Das Prozeßgas des erfindungsgemäßen Verfahrens kann Wasserstoff enthalten, weil in vielen Fällen die Anwesenheit des Wasserstoffs den Verfahrenserfolg weiter verbessert. Sofern Wasserstoff mitverwendet wird, liegt das Volumenverhältnis (d) von Stickstoff zu Wasserstoff bei 2:1 bis 20:1. Dieses Verhältnis stellt einen optimalen Bereich dar, innerhalb dessen der Wasserstoffgehalt frei gewählt und den übrigen Verfahrensparametern in geeigneter Weise angepaßt werden kann.

Die Auswahl der Verfahrensparameter des erfindungsgemäßen Verfahrens erfolgt aus den vorstehend angegebenen erfindungsgemäß obligatorischen Bereichen für die Volumenverhältnisse (b) und (c) der erfindungsgemäß zu verwendenden Prozeßgase. Darüber hinaus können die Verfahrensparameter aus den vorstehend angegebenen fakultativen Bereichen für das Volumenverhältnis (d) von Stickstoff zu Wasserstoff, für die Abscheiderate, für die Kathodenleistung P und für den Prozeßgasdruck ausgewählt werden. Es ist von Vorteil, wenn alle diese Parameter aus den angegebenen Bereichen ausgewählt werden.

In gewissem Umfang richtet sich die engere Auswahl der Verfahrensparameter, d.h. der Verfahrensbedingungen, nach der Natur der Oberfläche, auf welcher die dünnen, röntgenamorphen Aluminiumnitrid- und Aluminiumsiliciumnitridschichten abgeschieden werden. Diese engere Auswahl kann anhand einfacher Vorversuche getroffen werden.

Beispiele geeigneter Verfahrensbedingungen oder Kombinationen von Verfahrensparametern, welche sich bei zahlreichen unterschiedlichen Oberflächen bewähren und aufgrund derer vorteilhafte, dünne röntgenamorphe Aluminiumnitrid- und Aluminiumsiliciumnitridschichten erhalten werden, sind:

I. $10^{-3}$ mbar Ar, $5 \cdot 10^{-4}$ mbar Ne, $2 \cdot 10^{-4}$ mbar $N_2$, Abscheiderate: 0,9 nm•s$^{-1}$, P = 1 kW;

II. $10^{-3}$ mbar Ar, $4 \cdot 10^{-4}$ mbar Ne, $2 \cdot 10^{-4}$ mbar $N_2$, $8 \cdot 10^{-5}$ mbar $H_2$, Abscheiderate: 1,1 nm•s$^{-1}$, P = 1,2 kW;

III. $3 \cdot 10^{-3}$ mbar Ar, $5 \cdot 10^{-4}$ mbar Kr, $2,5 \cdot 10^{-4}$ mbar $N_2$, Abscheiderate: 1 nm•s$^{-1}$, P = 1 kW;

IV. $2 \cdot 10^{-3}$ mbar Ar, $2 \cdot 10^{-4}$ mbar Xe, $2 \cdot 10^{-4}$ mbar Kr, $3 \cdot 10^{-4}$ mbar $N_2$, Abscheiderate: 0,9 nm•s$^{-1}$, P = 1 kW;

V. $2 \cdot 10^{-3}$ mbar Ar, $10^{-4}$ mbar Xe, $10^{-4}$ mbar Ne, $4,2 \cdot 10^{-4}$ mbar $N_2$, $4,2 \cdot 10^{-5}$ mbar $H_2$, Abscheiderate: 1,2 nm•s$^{-1}$, P = 1,2 kW; oder

VI. $3 \cdot 10^{-3}$ mbar Ar, $1,5 \cdot 10^{-4}$ mbar Xe, $5,7 \cdot 10^{-4}$ mbar $N_2$, Abscheiderate: 1,1 nm•s$^{-1}$, P = 1,5 kW.

Das erfindungsgemäße Verfahren weist zahlreiche besondere Vorteile auf.

So lassen sich mit Hilfe des erfindungsgemäßen Verfahrens dünne röntgenamorphe Aluminiumnitrid- oder Aluminiumsiliciumnitridschichten auf den unterschiedlichsten Oberflächen wie etwa denen von Halbleiterplättchen ("wafer"), Glas, Polymeren, Metallschichten oder Farbstoffschichten herstellen. Hierbei erweist sich das erfindungsgemäße Verfahren dann als besonders vorteilhaft, wenn hiermit dünne röntgenamorphe Aluminiumnitrid- oder Aluminiumsiliciumnitridschichten, d.h. Schichten einer Dicke von 0,1 bis 1000 nm, erzeugt werden. Diese in erfindungsgemäßer Verfahrensweise hergestellten Schichten weisen vorzügliche anwendungstechnische Eigenschaften auf, so daß sie z.B. als elektrische Isolierschichten, als Lichtwellenleiter, als Leiter akustischer Wellen, als Schutzschichten für integrierte Schaltkreise ("micro-chips") oder als Interferenz- und/oder als Schutzschichten in flächenförmigen, mehrschichtigen laseroptischen und magneto-optischen Aufzeichnungsmaterialien mit wasser- und luftempfindlichen Aufzeichnungsschichten verwendet werden können.

Gerade auf dem technischen Gebiet der flächenförmigen, mehrschichtigen laseroptischen und magneto-optischen Aufzeichnungsmaterialien treten die Vorteile des erfindungsgemäßen Verfahrens offen zu Tage: So sind nicht nur die hiermit erhaltenen Verfahrensprodukte vorzüglich für die genannten Verwendungszwecke geeignet, sondern das erfindungsgemäße Verfahren selbst läßt sich rationell in das Verfahren zur Herstellung dieser Aufzeichnungsmaterialien integrieren.

Flächenförmige, mehrschichtige laseroptische und magneto-optische Aufzeichnungsmaterialien, welche im allgemeinen einen optisch transparenten dimensionsstabilen Träger (A) und eine thermisch veränderbare Aufzeichnungsschicht (B) enthalten, sind bekannt.

Dabei umfaßt der Begriff "flächenförmig" alle Raumformen, deren Dicke erheblich kleiner ist als ihre Länge und Breite. Demnach kann es sich hier um band-, platten- oder scheibenförmige Aufzeichnungsmaterialien handeln, wobei die scheibenförmigen im allgemeinen auch als Datenplatten oder Disks bezeichnet werden.

In die Aufzeichnungsschichten (B) laseroptischer Aufzeichnungsmaterialien werden digitale Daten mit Hilfe impulsmodulierter Schreiblaserstrahlen in Form thermisch veränderter Bereiche eingeschrieben. Dabei sind die Schreiblaserstrahlen auf die Aufzeichnungsschichten (B) fokussiert und treffen senkrecht auf sie auf. Für das Einschreiben analoger Daten können auch Dauerstrichlaser angewendet werden. Im Falle eingeschriebener digitaler Daten haben die thermisch veränderten Bereiche der Aufzeichnungsschichten (B) eine runde oder elliptische Grundfläche. Im Falle analoger Daten sind die thermisch veränderten Bereiche von beliebiger Grundfläche.

Für das Lesen der Daten verwendet man im allgemeinen kontinuierlich emittierte Leselaserstrahlen (Dauerstrichlaserstrahlen), deren Energie nicht dazu ausreicht, weitere Veränderungen in den Aufzeichnungsschichten (B) hervorzurufen. Die Leselaserstrahlen sind dabei gleichfalls auf die Aufzeichnungsschichten (B) fokussiert und treffen senkrecht auf diese auf. Beim Lesevorgang wird im allgemeinen das von den Aufzeichnungsschichten (B) reflektierte Licht mit Hilfe geeigneter optischer Anordnungen erfaßt, üblichen und bekannten Detektoren zugeführt und durch geeignete elektronische Apparate in Signale umgewandelt.

Diese Schreib- und Leseverfahren sowie die entsprechenden hierfür geeigneten Aufzeichnungsmaterialien kennzeichnet man daher im allgemeinen mit dem Begriff "laseroptisch".

Dabei können die thermisch veränderten Bereiche der Aufzeichnungsschichten (B) die Form von Löchern haben, welche die Aufzeichnungsschicht ganz durchdringen. In diesem Fall spricht man allgemein vom ablativen laseroptischen Schreiben von Daten. Beim Lesen der Daten mit einem Leselaserstrahl wird die unterschiedliche Reflektivität der Löcher und der unveränderten Bereiche der Aufzeichnungsschicht (B) ausgenutzt. Um hierbei eine hohe Empfindlichkeit und ein hohes Signal-Rausch-Verhältnis zu erzielen, kann eine Reflektorschicht mitverwendet werden, die durch die Lochbildung freigelegt wird und den Leselaserstrahl besonders stark reflektiert.

Die thermisch veränderten Bereiche können auch die Form von Kratern ("pits") haben, welche gegebenenfalls einen sauber ausgebildeten Kraterrand ("wall") aufweisen. In diesem Falle spricht man vom deformativen laseroptischen Schreiben von Daten. Hierbei werden die Daten über die Beugung des Lichts des Leselaserstrahls an den Kratern ausgelesen.

Durch die thermische Veränderung können indes auch Bereiche entstehen, in denen keine Ablation oder Deformation, sondern eine Phasenumwandlung des Materials der Aufzeichnungsschicht (B) in eine andere Stoffmodifikation stattgefunden hat. In einem solchen Falle spricht man vom laseroptischen Schreiben von Daten durch Phasenumwandlung. Im allgemeinen wird durch die Phasenumwandlung die Reflektivität in den beschriebenen Bereichen erniedrigt und/oder die Lichtdurchlässigkeit erhöht. Indessen kann es unter Umständen auch zum gegenteiligen Effekt kommen, d.h. die Reflektivität wird erhöht und/oder die Lichtdurchlässigkeit erniedrigt. Im allgemeinen werden die in dieser Weise thermisch veränderten Bereiche als Flecke ("spots") bezeichnet.

Die Aufzeichnungsschichten (B) können indes auch mit Schichten unterlegt sein, welche sich beim Bestrahlen ausdehnen oder Gase entwickeln, wodurch die Aufzeichnungsschichten (B) lokal gedehnt werden. In dieser Weise bilden sich in der Oberfläche der Aufzeichnungsschichten (B) Reliefstrukturen aus, welche die eingeschriebenen Daten beinhalten.

Die Gase können aber auch in den Aufzeichnungsschichten (B) selbst unter Bildung kleiner lichtstreuender Bläschen freigesetzt werden. Dies nennt man im allgemeinen vesikulare Datenaufzeichnung.

Außerdem kann in den thermisch veränderten Bereichen eine chemische Reaktion eines Bestandteils oder eine chemische Reaktion zwischen mehreren Bestandteilen der Aufzeichnungsschichten (B) stattgefunden haben, wodurch die optischen Eigenschaften der Aufzeichnungsschichten (B) in diesen Bereichen geändert worden sind.

Eine lokale Erhöhung der Reflektion von Aufzeichnungsschichten (B) beim Bestrahlen kann aber auch über die Vergrößerung oder das Zusammenschmelzen von kleinen Partikeln zustandekommen. Diese kleinen Partikel, beispielsweise Goldkörnchen, können dabei in eine Matrix eingelagert sein. Es kann sich dabei aber auch um metallbedampfte Kunststoffkügelchen handeln.

Aufzeichnungsschichten (B), welche aus diesen Kügelchen bestehen, weisen eine überaus niedrige Grundreflektivität auf.

Eine besonders vorteilhafte Aufzeichnungsschicht (B), welche sich insbesondere für das ablative oder deformative Schreiben von Daten eignet, besteht bekanntermaßen aus dem höchst wasser- und luftempfindlichen Tellur. Die dünnen röntgenamorphen Aluminiumnitrid- oder Aluminiumsiliciumnitrid-Schichten, welche nach dem erfindungsgemäßen Verfahren auf der Tellurschicht (B) aufgebracht werden, schützen die Tellurschicht (B) hervorragend vor Korrosion, verlängern ihre Lebensdauer und verbessern ihr Signal-Rausch-Verhältnis.

Nicht zuletzt können die thermisch veränderten Bereiche in Aufzeichnungsschichten (B), welche aus senkrecht zu ihrer Oberfläche magnetisierten, amorphen ferrimagnetischen Schichten bestehen, die Form von Flecken ("spots") haben, welche eine der ursprünglichen Richtung entgegengesetzte Magnetisierungsrichtung aufweisen. Diese "spots" entstehen beim Erwärmen des ferrimagnetischen Materials dieser Schichten durch einen Laserstrahl unter dem Einfluß eines anliegenden (externen) magnetischen Hilfsfeldes oder eines der Aufzeichnungsschicht (B) immanenten (intrinsischen) Magnetfeldes: Durch die Erwärmung nimmt die Koerzitivfeldstärke $H_c$ des ferrimagnetischen Materials ab. Unterschreitet dabei die Koerzitivfeldstärke $H_c$ bei einer von dem jeweils verwendeten Material abhängigen kritischen Temperatur die Feldstärke des externen oder des intrinsischen Magnetfeldes, so wird der betreffende Bereich ummagnetisiert.

7

Im Bedarfsfalle können die eingeschriebenen Daten durch gezieltes lokales Erhitzen der Aufzeichnungsschicht (B) z.B. mittels eines Laserstrahls bei gleichzeitiger Einwirkung eines externen oder eines intrinsischen magnetischen Feldes, dessen Feldlinien senkrecht zur Schichtoberfläche ausgerichtet sind, wieder gelöscht werden, wonach man erneut in der vorstehend beschriebenen Weise Daten einschreiben kann. D.h. der Schreibvorgang ist reversibel.

Für das Lesen der thermisch veränderten Bereiche verwendet man linear polarisiertes Licht eines kontinuierlich emittierenden Dauerstrichlasers, dessen Lichtleistung nicht dazu ausreicht, das Material über die kritische Temperatur hinaus zu erwärmen. Dieser Laserstrahl wird entweder von der Aufzeichnungsschicht (B) selbst oder von einer hinter ihr angeordneten Reflektionsschicht reflektiert, wobei es zu einer Wechselwirkung zwischen den magnetischen Momenten in der Aufzeichnungsschicht (B) und dem magnetischen Vektor der Laserlichtwelle kommt. Durch diese Wechselwirkung wird die Ebene der Polarisation E des Laserlichts, welches von einem "spot" oder von einer dahinter liegenden Reflexionsschicht reflektiert wird, gegenüber der ursprünglichen Ebene um einen kleinen Winkel gedreht. Geschieht diese Drehung der Ebene der Polarisation $\vec{E}$ bei der Reflexion des Lichts an der Aufzeichnungsschicht (B) selbst, so bezeichnet man dies als Kerr-Effekt und den Drehwinkel demnach als Kerr-Drehwinkel; wird dagegen die Ebene beim zweimaligen Durchgang des Lichts durch die Aufzeichnungsschicht gedreht, so spricht man vom Faraday-Effekt und vom Faraday-Drehwinkel.

Diese Drehung der Ebene der Polarisation $\vec{E}$ des vom Aufzeichnungsmaterial reflektierten Laserlichts kann mit Hilfe geeigneter optischer und elektronischer Geräte gemessen und in Signale umgesetzt werden. Aufzeichnungsschichten (B) dieser Art kennzeichnet man daher im allgemeinen mit dem Begriff "magneto-optisch".

Im Falle mehrschichtiger laseroptischer und magneto-optischer Datenplatten verwendet man im allgemeinen zum Schreiben und Lesen digitaler Daten die üblichen und bekannten Plattenlaufwerke. Ein solches Plattenlaufwerk enthält im wesentlichen einen Plattendrehteller und einen laseroptischen Schreib- und Lesekopf, dazu noch mechanische Servoeinrichtungen zur Korrektur der Spurlage, Autofokussiereinrichtungen, optische Elemente zur Analyse von Spurlagen- und Autofokusfehlern, Detektoreinrichtungen mit vorgeschalteten optischen Komponenten zur Erfassung des von den Datenplatten reflektierten Lichts des Leselaserstrahls sowie geeignete elektronische Bauteile. Üblicherweise enthält ein laseroptischer Schreib- und Lesekopf Laserdioden, welche Infrarotlicht emittieren, und aus Halbleitermaterialien wie GaAlAs bestehen. Darüber hinaus weist ein solcher Schreib- und Lesekopf im allgemeinen noch weitere geeignete optische Bauteile wie dielektrische Strahlteiler, Polarisationsstrahlteiler oder polarisationsunabhängige Strahlteiler sowie eine λ/4- oder λ/2-Platte auf.

Die besonderen Vorteile des erfindungsgemäßen Verfahrens werden in hervorragender Weise anhand der magneto-optischen Aufzeichnungsmaterialien deutlich.

Bekanntermaßen stellt man flächenförmige, mehrschichtige magneto-optische Aufzeichnungsmaterialien, welche

(A) einen optisch transparenten dimensionsstabilen Träger,

(B) eine thermisch veränderbare, aus einer Lanthanid-Übergangsmetall-Legierung aufgebauten Aufzeichnungsschicht und

(C) eine Aluminiumnitrid- und/oder Aluminiumsiliciumnitridschicht auf einer oder auf beiden Seiten der Aufzeichnungsschicht (B)

aufweisen, durch ein Verfahren her, bei welchem man

(i) die einzelnen Schichten (B) und (C) auf dem Träger (A) in der gewünschten Reihenfolge, Anzahl und Dicke und mit dem jeweils gewünschten inneren Aufbau über die Gasphase aufbringt, wobei man

(ii) die Schicht(en) (C) durch reaktive Kathodenzerstäubung oder reaktive Magnetronkathodenzerstäubung von Aluminium oder von Aluminium und Silicium in Vakuum in einer Edelgas und Stickstoff enthaltenden Proezßgasatmosphäre erzeugt, wonach man

(iii) in der Aufzeichnungsschicht (B) eine definierte, senkrecht zu ihrer Oberfläche orientierte Magnetisierung induziert.

Hierbei erweist es sich von ganz besonderem Vorteil, wenn man zwecks Herstellung der Schicht(en) (C) das vorstehend im Detail beschriebene erfindungsgemäße Verfahren anwendet, wobei sich das Verfahren zwanglos und rationell in den Rahmen des Verfahrens zur Herstellung des flächenförmigen, mehrschichtigen mangeto-optischen Aufzeichnungsmaterials einfügt.

Ein zusätzlicher Vorteil ergibt sich, wenn man zumindest auf der dem Träger (A) abgewandten und nach dem erfindungsgemäßen Verfahren hergestellten, dünnen röntgenamorphen Aluminiumnitrid- oder Aluminiumsiliciumnitridschicht eine Oxidschicht (C') in an sich bekannter Weise erzeugt, wobei die Dicke der Oxidschicht (C') das 0,2- bis 0,8fache, insbesondere das 0,25- bis 0,75fache der Dicke der Schicht (C) ist.

Sofern die Dicke der Schicht (C') das 0,25- bis 0,75fache der Dicke der Schicht (C) ist, sind für den Aufbau der Schicht (C') die folgenden Oxide besonders gut geeignet: $Al_2O_3$, $SiO_2$, SiO, PbO, $Pb_2O_3$, $SnO_2$, $Y_2O_3$, $ZrO_2$, $HfO_2$, $MoO_3$, $Nb_2O_5$, $Ta_2O_5$, $TiO_2$, $ThO_2$ oder das Oxid, welches von der Elementzusammensetzung I

$$(Al_xSi_{1-x})_{1-z}(M^1_rM^2_sM^3_t)z \qquad I$$

gebildet wird, worin die Indices und die Variablen die folgende Bedeutung haben:

| | |
|---|---|
| $M^1$, $M^2$ und $M^3$ | Ti, Zr, Hf, Th, Sc, Y, La, Ce, Pr, Nd, Sm, Eu, Gd, Tb, Dy, Ho, Er, Tm, Yb, Lu, V, Nb, Ta, Cr, Mo, W, Mn, Re, Fe, Co, Rh, Cu, Zn, Mg, Ca, Sr, Ba, B, Ga, In, Tl, Ge, Sn, Pb, P, As, Sb und Te, mit den Maßgaben, daß $M^1$, $M^2$ und $M^3$ voneinander verschieden sind oder daß sie gleich oder verschieden voneinander sind, wenn es sich bei $M^1$, $M^2$ und $M^3$ um Lanthan oder ein Lanthanid handelt; |
| x | 0 bis 1; |
| z | r + s + t; |
| r | 0,005 bis 0,15; |
| s | 0,005 bis 0,15; |
| t | 0 bis 0,005. |

Vorteilhafte Träger (A) sind die üblichen und bekannten, scheibenförmigen, optisch klaren dimensionsstabilen Träger (A) eines Durchmessers von 90 oder 130 mm und einer Dicke von 1,2 mm. Sie bestehen im allgemeinen aus Glas oder aus Kunststoffen wie z.B. Polycarbonat, Polymethylmethacrylat, Polymethylpenten, Celluloseacetobutyrat oder aus Gemischen aus Poly(vinylidenfluorid) und Polymethylmethacrylat oder Polystyrol und Poly(2,6-dimethylphen-1,4-ylen-ether). Hiervon sind die Träger (A) aus Kunststoffen besonders vorteilhaft.

Diejenige Oberfläche des Trägers (A), welche der Aufzeichnungsschicht (B) zugekehrt ist, kann Strukturen aufweisen.

Die Strukturen in der Oberfläche des Trägers (A) liegen im Mikrometer- und/oder Submikrometer-Bereich. Sie dienen der exakten Führung des Leselaserstrahls und gewährleisten ein rasches und genaues Ansprechen der Spurlagenservo- und Autofokussiereinrichtung in den laseroptischen Schreib- und Leseköpfen der Plattenlaufwerke, d.h. sie ermöglichen oder verbessern das "tracking". Außerdem können diese Strukturen selbst Daten sein, so wie dies beispielsweise bei den bekannten Audio- oder Video-Kompakt-Disks der Fall ist, oder sie können der Codierung der eingeschriebenen Daten dienen. Die Strukturen bestehen aus erhabenen Teilen und/oder Vertiefungen. Diese liegen in der Form von durchgehenden konzentrischen oder spiralförmigen Spurrillen oder als isolierte Hügel und/oder Löcher vor. Außerdem kann die Struktur eine mehr oder weniger glatte Wellenform haben. Den Spurrillen wird hierbei der Vorzug gegeben. Sie wiesen in ihrer Querrichtung eine rechteckige sägezahnartige, eine V-förmige oder eine trapezartige Kontur auf. Ihre Vertiefungen werden im allgemeinen als "grooves" und ihre erhabenen Teile als "land" bezeichnet. Von besonderem Vorteil sind Spurrillen mit 50 bis 200 nm tiefen und 0,4 bis 0,8 $\mu$m breiten "grooves", zwischen denen jeweils ein 1 bis 3 $\mu$m breites "land" liegt.

Vorteilhafte magneto-optische Aufzeichnungsschichten (B) enthalten im wesentlichen eine armophe Lanthanid-Übergangsmetall-Legierung. Diese Aufzeichnungsschichten (B) sind im allgemeinen 10 bis 500 nm dick. Für den Aufbau der Aufzeichnungsschichten (B) kommen die Lanthanide Pr, Nd, Sm, Eu, Gd, Tb, Dy und Ho und die Übergangsmetalle Fe und Co in Betracht. Geeignete Mischungsverhältnisse von Lanthaniden zu Übergangsmetallen sind vom Stand der Technik her bekannt. Darüber hinaus kann die amorphe Lanthanid-Übergangsmetall-Legierung noch weitere Elemente wie Sc, Y, La, V, Nb, Ta, Cr, Mo, W, Mn, Ni, Re, Ru, Os, Rh, Ir, Pd, Pt, Cu, Ag, Au, Zn, B, Al, Ga, In, Si, Ge, Sn, Pb, P, As, Sb und/oder Bi in üblichen und bekannten Mengen enthalten.

Darüber hinaus kann das magneto-optische Aufzeichnungsmaterial weitere Schichten enthalten, welche für die Funktion des Aufzeichnungsmaterials von Nutzen sind. Hierbei handelt es sich um die üblichen und bekannten Interferenzschichten, Reflexionsschichten, Antikorrosionsschichten, Haftschichten oder um weitere magnetisierbare Schichten. Außerdem können zwei magneto-optische Aufzeichnungsmaterialien "sandwich"-artig miteinander verbunden werden, so daß ihre Aufzeichnungsschichten (B) einander zugekehrt sind und ein gewisser Abstand zwischen ihnen herrscht, wobei die üblichen und bekannten Techniken zum Verbinden zweier Aufzeichnungsmaterialien angewandt werden.

Die flächenförmigen, mehrschichtigen magneto-optischen Aufzeichnungsmaterialien, welche eine oder zwei der in erfindungsgemäßer Verfahrensweise erzeugten Schichten (C) enthalten, können in der üblichen Weise von der Seite des optisch transparenten dimensionsstabilen Trägers (A) her mit Hilfe eines impulsmodulierten, auf die Aufzeichnungsschichten (B) fokussierten und senkrecht auf diese auftreffenden Schreiblaserstrahls einer Wellenlange λ von kleiner als 1000 nm mit Daten in Form ummagnetisierter "spots" beschrieben werden. Hiernach können die Daten mit Hilfe eines auf die beschriebenen Aufzeichnungsschichten (B) fokussierten und senkrecht auf sie auftreffenden Dauerstrichlaserstrahls gelesen werden, wobei man das von den Aufzeichnungsschichten (B) selbst oder das von den gegebenenfalls vorhandenen Reflexionsschichten reflektierte Licht erfaßt, analysiert und in Signale umwandelt. Im Falle der Datenplatten oder Disks können hierfür die üblichen und bekannten laseroptischen Plattenlaufwerke mit laseroptischen Köpfen, welche Halbleiterlaser enthalten, verwendet werden.

Dabei weisen die flächenförmigen, mehrschichtigen magneto-optischen Aufzeichnungsmaterialien, welche eine oder zwei der in erfindungsgemäßer Verfahrensweise erzeugten Schicht(en) (C) enthalten, gegenüber dem Stand der Technik besondere Vorteile auf. So haben sie eine höhere Empfindlichkeit als bekannte Aufzeichnungsmaterialien, weswegen sie mit geringerer Laserleistung beschrieben werden können. In der Form magneto-optischer Datenplatten (Disks) können sie daher - bei gleicher Laserleistung - bei höheren Plattendrehzahlen beschrieben werden als bekannte Disks. Auch ihre Bitdichte ist gegenüber dem Stand der Technik deutlich erhöht. Beim Lesen liefern sie unverzerrte Signale und weisen ein Signal-Rausch-Verhältnis von mehr als 55 dB auf. Selbst nach einer Lagerzeit von mehr als 1000 Stunden bei 70°C und einer relativen Luftfeuchtigkeit von 90 % kommt es nicht zu einer Erhöhung der Bitfehlerrate ("bit error rate"), d.h. es tritt kein Informationsverlust auf.

Darüber hinaus sind die in den mehrschichtigen, flächenförmigen magneto-optischen Aufzeichnungsmaterialien enthaltenen, in erfindungsgemäßer Verfahrensweise hergestellten, dünnen röntgenamorphen Aluminiumnitrid-und/oder Aluminiumsiliciumnitridschichten (C) kratzfest, hart, haftfest, mechanisch fest und nicht spröde. Dienen diese Schichten (C) als Antikorrosionsschichten, so schirmen sie die äußerst luft- und wasserempfindlichen Aufzeichnungsschichten (B) hervorragend ab. Werden sie als Interferenzschichten zwischen den Trägern (A) und den Aufzeichnungsschichten (B) verwendet, so sind sie in ihrer optischen Anpassungswirkung den in üblicher und bekannter Weise hergestellten Interferenzschichten überlegen. Hinzu kommt noch, daß auch in dieser Funktion die in erfindungsgemäßer Verfahrensweise hergestellten Schichten (C) ihre hervorragende Korrosionsschutzwirkung entfalten und dadurch zu der besonders langen Lebensdauer der betreffenden flächenförmigen, mehrschichtigen, magneto-optischen Aufzeichnungsmaterialien wesentlich beitragen.

Beispiele

Beispiele 1 bis 6

Die Herstellung dünner röntgenamorpher Aluminiumnitrid- und Aluminiumsiliciumnitridschichten nach dem erfindungsgemäßen Verfahren und die anwendungstechnischen Eigenschaften der so erhaltenen Schichten (C)

Versuchsvorschrift:

Die Herstellung dünner röntgenamorpher Aluminiumnitrid- und Aluminiumsiliciumnitridschichten (C) nach dem erfindungsgemäßen Verfahren wurde im Rahmen der Herstellung magneto-optischer Datenplatten und somit praxisgerecht durchgeführt. Der besondere technische Effekt des erfindungsgemäßen Verfahrens trat hiernach anhand der vorteilhaften Eigenschaften der Aufzeichnungsmaterialien besonders deutlich zu Tage.

Als Träger (A) wurden sechs 130 mm durchmessende, 1,2 mm dicke, mit Spurrillen versehene Scheiben aus einem Gemisch aus Polystyrol und Poly(2,6-dimethylphen-1,4-ylen-ether) verwendet.

Auf die mit Spurrillen versehene Seite der sechs Scheiben (A) wurden unter Drehen der Scheiben (A) die einzelnen Schichten (B) und (C) in der gewünschten Anzahl, Reihenfolge und Dicke und mit dem jeweils gewünschten inneren Aufbau aus der Gasphase aufgebracht.

Dabei erfolgte zunächst das Aufbringen der röntgenamorphen Interferenz-schicht (C) aus Aluminiumsiliciumnitrid auf der Oberfläche der Träger (A) durch reaktive Magnetronkathodenzerstäubung eines Aluminium/Silicium-"targets", wobei das erfindungsgemäße Verfahren zum Tragen kam. Hierbei wurden die folgenden Verfahrensbedingungen angewandt:

Beispiel 1

| Prozeßgas: | $10^{-3}$ mbar Ar, $5 \cdot 10^{-4}$ mbar Ne, $2 \cdot 10^{-4}$ mbar $N_2$; |
|---|---|
| Abscheiderate: | 0,9 nm$\cdot$s$^{-1}$; |
| Kathodenleistung: | P = 1 kW; |

Beispiel 2

| Prozeßgas: | $10^{-3}$ mbar Ar, $4 \cdot 10^{-4}$ mbar Ne, $2 \cdot 10^{-4}$ mbar $N_2$; $8 \cdot 10^{-5}$ mbar $H_2$; |
|---|---|
| Abscheiderate: | 1,1 nm$\cdot$s$^{-1}$; |
| Kathodenleistung: | P = 1,2 kW; |

Beispiel 3

| Prozeßgas: | $3 \cdot 10^{-3}$ mbar Ar, $5 \cdot 10^{-4}$ mbar Kr, $2,5 \cdot 10^{-4}$ mbar $N_2$; |
|---|---|
| Abscheiderate: | 1,0 nm$\cdot$s$^{-1}$; |
| Kathodenleistung: | P = 1 kW; |

Beispiel 4

| Prozeßgas: | $2 \cdot 10^{-3}$ mbar Ar, $2 \cdot 10^{-4}$ mbar Xe, $2 \cdot 10^{-4}$ mbar Kr, $3 \cdot 10^{-4}$ mbar $N_2$; |
|---|---|
| Abscheiderate: | 0,9 nm$\cdot$s$^{-1}$; |
| Kathodenleistung: | P = 1 kW; |

Beispiel 5

| Prozeßgas: | $2 \cdot 10^{-3}$ mbar Ar, $10^{-4}$ mbar Xe, $10^{-4}$ mbar Ne, $4,2 \cdot 10^{-4}$ mbar $N_2$, $4,2 \cdot 10^{-5}$ mbar $H_2$; |
|---|---|
| Abscheiderate: | 1,2 nm$\cdot$s$^{-1}$; |
| Kathodenleistung: | P = 1,2 kW; |

Beispiel 6

| Prozeßgas: | $3 \cdot 10^{-3}$ mbar Ar, $1,5 \cdot 10^{-4}$ mbar Xe, $5,7 \cdot 10^{-4}$ mbar $N_2$; |
|---|---|
| Abscheiderate: | 1,1 nm$\cdot$s$^{-1}$; |
| Kathodenleistung: | P = 1,5 kW. |

Hiernach wurden die aus einer TbDyFe-Legierung bestehenden, amorphen magneto-optischen Aufzeichnungsschichten (B) durch Magnetronkathodenzerstäubung eines TbDyFe-"targets" auf der Oberfläche der Interferenz-schichten (C) in üblicher und bekannter Weise hergestellt.

Auf die Oberfläche der Aufzeichnungsschichten (B) wurden anschließend die Antikorrosionsschichten (C) aus röntgenamorphem Aluminiumnitrid (Beispiele 1 bis 3) oder aus Aluminiumsiliciumnitrid (Beispiele 4

11

bis 6) nach dem erfindungsgemäßen Verfahren aufgebracht, wobei auch hier bei den einzelnen Beispielen die vorstehend angegebenen jeweiligen Verfahrensbedingungen für die Herstellung der Schichten (C) angewandt wurden.

Bei Beispiel 3 wurde auf die Oberfläche der Antikorrosionsschichten (C) noch eine Tantaloxidschicht (C') und bei Beispiel 6 eine Titandioxidschicht (C') in üblicher und bekannter Weise durch reaktive Magnetronkathodenzerstäubung in einer Argon und Sauerstoff enthaltenden Prozeßgasatmosphäre aufgebracht.

Bei dem Verfahren zur Herstellung der magneto-optischen Datenplatten wurden die Verfahrensbedingungen insgesamt so gewählt, daß die in der Tabelle 1 angegebenen Zusammensetzungen der Datenplatten 1 bis 6 resultierten.

Zur Überprüfung des Verfahrenserfolgs und zu analytischen Zwecken wurden weitere sechs magneto-optische Datenplatten unter jeweils exakt vergleichbaren Bedingungen hergestellt (Beispiele 1a bis 6a). Anhand dieser Datenplatten wurden die Morphologie und die stoffliche Zusammensetzung der nach dem erfindungsgemäßen Verfahren hergestellten neuen Schichten (C) mittels üblicher und bekannter, z.T. materialabbauender Analysenmethoden wie chemische Elementaranalyse, Lichtmikroskopie, Rasterelektronenmikroskopie, Röntgenspektroskopie, Röntgenstreuung oder -beugung, ESCA (Elektronenspektroskopie für die chemische Analyse) und Flammenphotometrie untersucht. Desweiteren wurde anhand üblicher und bekannter zerstörungsfreier optischer und spektroskopischer Methoden verifiziert, daß die jeweiligen Schichten (C) der Beispielspaare (1, 1a) bis (6, 6a) jeweils miteinander identisch waren, so daß die anhand der Beispiele 1a bis 6a ermittelten stofflichen und morphologischen Parameter in die Tabelle 1 miteinfließen konnten.

Die Aufzeichnungsschichten (B) der magneto-optischen Datenplatten der Beispiele 1 bis 6 wurden unmittelbar nach ihrer Herstellung senkrecht zu ihrer Oberfläche magnetisiert. Anschließend wurden die Datenplatten während 48 Stunden bei 23 ± 2°C bei einem Luftdruck von 103 ± 3,5 kPa und bei einer relativen Luftfeuchtigkeit von 45 bis 55 % konditioniert.

Hiernach wurden die konditionierten Datenplatten mit Hilfe eines üblicchen und bekannten Plattenlaufwerks unter exakt vergleichbaren Bedingungen mit Daten beschrieben. Hierzu verwendete man einen impulsmodulierten GaAlAs-Halbleiterlaser, welcher linear polarisiertes Licht der Wellenlänge $\lambda$ = 830 nm emittierte. Sowohl die Bitlänge, d.h. der Durchmesser der ummagnetisierten "spots" als auch der Bitabstand, d.h. der Abstand von "spot" zu "spot", lagen bei etwa 1 $\mu$m.

Für das Lesen der eingeschriebenen Daten über den Kerr-Effekt verwendete man den GaAlAs-Halbleiterlaser im Dauerstrichbetrieb mit einer Lichtleistung von kleiner als 1 mW. Die unkorrigierte Bitfehlerrate wurde in üblicher und bekannter Weise mittels eines Zeitintervall-Analysators ("time interval analyzer", TIA) bestimmt.

Die Datenplatten wurden zunächst unmittelbar nach dem Beschreiben gelesen (1. Lesen). Hiernach wurden die Datenplatten dem für magneto-optische Aufzeichnungsmaterialien typischen "beschleunigten Lebensdauertest" bei 60, 70 und 80°C bei einer relativen Luftfeuchte von 90 % unterworfen und hiernach erneut gelesen (2. Lesen). Aus den hierbei erhaltenen unkorrigierten Bitfehlerraten und aus der licht- und rasterelektronenmikroskopischen Begutachtung der Aufzeichnungsschichten (B) der Datenplatten wurde deren Lebensdauer unter Normalbedingungen (30°C, 90 % relative Luftfeuchte) abgeschätzt. Die betreffenden Ergebnisse finden sich in der Tabelle 2.

Vergleichsversuche V1 bis V6

Die Herstellung dünner Aluminiumnitrid- und Aluminiumsiliciumnitridschichten nach einem bekannten Verfahren und die anwendungstechnischen Eigenschaften der so erhaltenen Schichten (C)

Versuchsvorschrift:

Die Beispiele 1 bis 6 wurden wiederholt mit dem Unterschied, daß die Schichten (C) nach einem bekannten Verfahren der reaktiven Magnetronkathodenzerstäubung hergestellt wurden. Dabei wurden folgende Verfahrensbedingungen angewandt:

Vergleichsversuche V1 bis V6

Prozeßgas: $4 \cdot 10^{-3}$ mbar Ar, $1 \cdot 10^{-3}$ mbar $N_2$;
Abscheiderate: 1 nm$\cdot$s$^{-1}$;
P = 1,5 kW.

Die Verfahrensbedingungen wurden insgesamt so gewählt, daß sich die in der Tabelle 1 mitaufgeführten Zusammensetzungen der Vergleichsplatten V1 bis V6 ergaben. Die an den Vergleichsplatten V1 bis V6 ermittelten Versuchsergebnisse werden in der Tabelle 2 denjenigen aus den Beispielen 1 bis 6 gegenübergestellt.

Hierbei können

Beispiel 1 mit Vergleichsversuch V1,

Beispiel 2 mit Vergleichsversuch V2,

Beispiel 3 mit Vergleichsversuch V3,

Beispiel 4 mit Vergleichsversuch V4,

Beispiel 5 mit Vergleichsversuch V5 und

Beispiel 6 mit Vergleichsversuch V6

direkt verglichen werden.

Der Vergleich zeigt in unmißverständlicher Weise, daß die magneto-optischen Datenplatten, welche die in erfindungsgemäßer Weise hergestellten Schichten (C) enthielten (Beispiele 1 bis 6), den magneto-optischen Datenplatten, welche lediglich die in bekannter Weise hergestellten Schichten (C) enthielten (Vergleichsversuche V1 bis V6), eindeutig überlegen waren. Dies untermauert, daß das erfindungsgemäße Verfahren einen besonderen unerwarteten technischen Effekt zur Folge hat, welcher sogar noch im Rahmen eines umfassenderen Verfahrens (Herstellung mangeto-optischer Datenplatten) in hervorragender Weise deutlich wird.

Tabelle 1

Herstellung und Zusammensetzung magneto-optischer Datenplatten mit in erfindungsgemäßer Verfahrensweise hergestellten (Beispiele 1 bis 6) und mit in bekannter Weise hergestellten (Vergleichsversuche (A bis F) Schichten (C)

| Beispiel Nr. | Interferenz- schicht (C) (nm) | Aufzeichnungs- schicht (B) (nm) | Antikorrosions- schicht (C) (nm) | Oxidschicht (C') (nm) |
|---|---|---|---|---|
| 1 | Aluminium- siliciumnitrid röntgenamorph (75) | TbDyFe (80) | Aluminium- siliciumnitrid röntgenamorph (100) | - |
| 2 | Aluminium- siliciumnitrid röntgenamorph (80) | TbDyFe (90) | Aluminiumnitrid röntgenamorph (110) | - |
| 3 | Aluminium- siliciumnitrid röntgenamorph (75) | TbDyFe (80) | Aluminiumnitrid röntgenamorph (100) | $Ta_2O_5$ poly- kristallin (25) |
| 4 | Aluminium- siliciumnitrid röntgenamorph (85) | TbDyFe (85) | Aluminiumnitrid röntgenamorph (120) | - |
| 5 | Aluminium- siliciumnitrid röntgenamorph (90) | TbDyFe (95) | Aluminium- siliciumnitrid röntgenamorph (115) | - |
| 6 | Aluminium- siliciumnitrid röntgenamorph (85) | TbDyFe (80) | Aluminiumnitrid röntgenamorph (100) | $TiO_2$ poly- kristallin (75) |

14

Tabelle 1: Fortsetzung

| Vgl.-Versuche | Interferenz-schicht (C) (nm) | Aufzeichnungs-schicht (B) (nm) | Antikrrosions-schicht (C) (nm) | Oxidschicht (C') (nm) |
|---|---|---|---|---|
| V1 | Aluminium-siliciumnitrid semiamorph (75) | TbDyFe (80) | Aluminiumnitrid polykristallin (100) | - |
| V2 | Aluminium-siliciumnitrid polykristallin bis semiamorph (80) | TbDyFe (90) | Aluminiumnitrid polykristallin (110) | - |
| V3 | Aluminium-siliciumnitrid semiamorph mit amorphen Bereichen (75) | TbDyFe (80) | Aluminiumnitrid polykristallin (100) | Ta₂O₅ poly-kristallin (25) |
| V4 | Aluminium-siliciumnitrid röntgenamorph (85) | TbDyFe (85) | Aluminiumnitrid polykristallin (120) | - |
| V5 | Aluminium-siliciumnitrid röntgenamorph mit semiamorphen Bereichen (90) | TbDyFe (95) | Aluminium-siliciumnitrid polykristallin (115) | - |
| V6 | Aluminium-siliciumnitrid röntgenamorph (85) | TbDyFe (80) | Aluminiumnitrid polykristallin (100) | TiO₂ poly-kristallin (75) |

15

Tabelle 2: Versuchsergebnisse

| Beispiel | Bitfehlerrate (unkorrigiert) | | Lebensdauer (Jahre) | Lochfraß-korrosion[a] |
|---|---|---|---|---|
| | 1. Lesen | 2. Lesen | | |
| 1 | $< 10^{-5}$ | $10^{-5}$ | $\geqslant 15$ | nein |
| 2 | $< 10^{-5}$ | $< 10^{-5}$ | $> 15$ | nein |
| 3 | $< 10^{-5}$ | $< 10^{-5}$ | $> 15$ | nein |
| 4 | $< 10^{-5}$ | $< 10^{-5}$ | $> 15$ | nein |
| 5 | $< 10^{-5}$ | $10^{-5}$ | $\geqslant 15$ | nein |
| 6 | $< 10^{-5}$ | $< 10^{-5}$ | $> 15$ | nein |
| Vergleichs-versuche | | | | |
| V1 | $10^{-5}$ | $3 \cdot 10^{-4}$ | 10-11 | ja |
| V2 | $10^{-5}$ | $7 \cdot 10^{-4}$ | 10-11 | ja |
| V3 | $10^{-5}$ | $9 \cdot 10^{-4}$ | 12 | nein |
| V4 | $10^{-5}$ | $6 \cdot 10^{-4}$ | 10-11 | ja |
| V5 | $10^{-5}$ | $5 \cdot 10^{-4}$ | 11 | nein |
| V6 | $10^{-5}$ | $10^{-5}$ | 12 | nein |

[a] lichtmikroskopische und rasterelektronenmikroskopische Untersuchung;

## Patentansprüche

1. Verfahren zur Herstellung einer dünnen röntgenamorphen Aluminiumnitrid- oder Aluminiumsiliciumnitridschicht auf einer Oberfläche durch reaktive Kathodenzerstäubung oder reaktive Magnetronkathodenzerstäubung von Aluminium oder von Aluminium und Silicium im Vakuum in einer Edelgas und Stickstoff enthaltenden Prozeßgasatmosphäre und durch Abscheiden der betreffenden Nitridschicht aus der Gasphase, dadurch gekennzeichnet, daß man hierbei
   (a) als Edelgas ein Gemisch aus Argon und einem oder mehreren der Edelgase Neon, Krypton oder Xenon verwendet, wobei
   (b) das Volumenverhältnis von Argon zu den anderen Edelgasen bei 2:1 bis 100:1 liegt und wobei
   (c) das Volumenverhältnis des Edelgasgemischs (a) zu Stickstoff bei 2:1 bis 10:1 liegt.

2. Verfahren zur Herstellung einer dünnen röntgenamorphen Aluminiumnitrid- oder Aluminiumsiliciumnitridschicht auf einer Oberfläche nach Anspruch 1, dadurch gekennzeichnet, daß das Volumenverhältnis (c) des Edelgasgemisches (a) zu Stickstoff bei 3,5:1 bis 6,5:1 liegt.

3. Verfahren zur Herstellung einer dünnen röntgenamorphen Aluminiumnitrid- oder Aluminiumsiliciumnitridschicht auf einer Oberfläche nach Anspruch 1 oder 2, dadurch gekennzeichnet, daß das Prozeßgas Wasserstoff enthält.

4. Verfahren zur Herstellung einer dünnen röntgenamorphen Aluminiumnitrid- oder Aluminiumsiliciumnitridschicht auf einer Oberfläche nach Anspruch 3, dadurch gekennzeichnet, daß das Volumenverhältnis (d) von Stickstoff zu Wasserstoff bei 2:1 bis 20:1 liegt.

**5.** Verfahren zur Herstellung eines flächenförmigen, mehrschichtigen magneto-optischen Aufzeichnungsmaterials mit

(A) einem optisch transparenten dimensionsstabilen Träger,

(B) einer thermisch veränderbaren, aus einer Lanthanid-Übergangsmetall-Legierung aufgebauten Aufzeichnungsschicht und mit

(C) einer Aluminiumnitrid- und/oder Aluminiumsiliciumnitridschicht auf einer oder auf beiden Seiten der Aufzeichnungsschicht (B),

bei welchem man

(i) die einzelnen Schichten (B) und (C) auf dem Träger (A) in der gewünschten Reihenfolge, Anzahl und Dicke und mit dem jeweils gewünschten inneren Aufbau über die Gasphase aufbringt, wobei man

(ii) die Schicht(en) (C) durch reaktive Kathodenzerstäubung oder reaktive Magnetronkathodenzerstäubung von Aluminium oder von Aluminium und Silicium in Vakuum in einer Edelgas und Stickstoff enthaltenden Prozeßgasatmosphäre erzeugt, wonach man

(iii) in der Aufzeichnungsschicht (B) eine definierte, senkrecht zu ihrer Oberfläche orientierte Magnetisierung induziert,

dadurch gekennzeichnet, daß man bei der Erzeugung der Schicht(en) (C)

(a) als Edelgas ein Gemisch aus Argon und einem oder mehreren der Edelgase Neon, Krypton oder Xenon verwendet, wobei

(b) das Volumenverhältnis von Argon zu den anderen Edelgasen bei 2:1 bis 100:1 liegt und wobei

(c) das Volumenverhältnis des Edelgasgemischs (a) zu Stickstoff bei 2:1 bis 10:1 liegt.

**6.** Verfahren zur Herstellung eines flächenförmigen, mehrschichtigen magneto-optischen Aufzeichnungsmaterials nach Anspruch 5, dadurch gekennzeichnet, daß das Volumenverhältnis (c) des Edelgasgemisches (a) zu Stickstoff bei 3,5:1 bis 6,5:1 liegt.

**7.** Verfahren zur Herstellung eines flächenförmigen, mehrschichtigen magneto-optischen Aufzeichnungsmaterials nach einem der Ansprüche 5 oder 6, dadurch gekennzeichnet, daß das Prozeßgas Wasserstoff enthält.

**8.** Verfahren zur Herstellung eines flächenförmigen, mehrschichtigen magneto-optischen Aufzeichnungsmaterials nach Anspruch 7, dadurch gekennzeichnet, daß das Volumenverhältnis (d) von Stickstoff zu Wasserstoff bei 2:1 bis 20:1 liegt.

**9.** Verfahren zur Herstellung eines flächenförmigen, mehrschichtigen magneto-optischen Aufzeichnungsmaterials nach einem der Ansprüche 5 bis 8, dadurch gekennzeichnet, daß man zumindest auf der dem Träger (A) abgewandten Schicht (C) eine Oxidschicht (C') erzeugt, deren Dicke das 0,2- bis 0,8fache der Dicke der Schicht (C) ist.

**10.** Verfahren zur Herstellung eines flächenförmigen, mehrschichtigen magneto-optischen Aufzeichnungsmaterials nach Anspruch 15, dadurch gekennzeichnet, daß die Dicke der Oxidschicht (C') das 0,25- bis 0,75fache der Dicke der Schicht (C) ist, wobei man als Oxid $Al_2O_3$, $SiO_2$, $SiO$, $PbO$, $Pb_2O_3$, $SnO_2$, $Y_2O_3$, $ZrO_2$, $HfO_2$, $MoO_3$, $Nb_2O_5$, $Ta_2O_5$, $TiO_2$, $ThO_2$ oder ein Oxid, welches von den Elementarzusam-mensetzung I

$$(Al_xSi_{1-x})_{1-z}(M^1{}_rM^2{}_sM^3{}_t)_z \qquad I$$

gebildet wird, worin die Indices und die Variablen die folgende Bedeutung haben:

| | |
|---|---|
| $M^1$, $M^2$ und $M^3$ | Ti, Zr, Hf, Th, Sc, Y, La, Ce, Pr, Nd, Sm, Eu, Gd, Tb, Dy, Ho, Er, Tm, Yb, Lu, V, Nb, Ta, Cr, Mo, W, Mn, Re, Fe, Co, Rh, Cu, Zn, Ca, Mg, Sr, Ba, B, Ga, In, Tl, Ge, Sn, Pb, P, As, Sb und Te, mit den Maßgaben, daR $M^1$, $M^2$ und $M^3$ voneinander verschieden sind oder daß sie gleich oder voneinander verschieden sind, wenn es sich bei $M^1$. $M^2$ und $M^3$ um Lanthan oder um Lanthanid handelt; |
| $x$ | 0 bis 1; |
| $z$ | $r + s + t$; |
| $r$ | 0,005 bis 0,15; |
| $s$ | 0,005 bis 0,15; |
| $t$ | 0 bis 0,005, |

verwendet.

**Claims**

1.  A process for the production of a thin X-ray amorphous aluminum nitride or aluminum silicon nitride layer on a surface by reactive sputtering or reactive magnetron sputtering of aluminum or aluminum and silicon under reduced pressure in a process gas atmosphere containing a noble gas and nitrogen and by depositing the relevant nitride layer from the gas phase, wherein
    (a) the noble gas used is a mixture of argon and one or more of the noble gases neon, krypton or xenon,
    (b) the volume ratio of argon to the other noble gases being from 2 : 1 to 100 : 1 and
    (c) the volume ratio of the noble gas mixture (a) to nitrogen being from 2 : 1 to 10 : 1.

2.  A process for the production of a thin X-ray amorphous aluminum nitride or aluminum silicon nitride layer on a surface as claimed in claim 1, wherein the volume ratio (c) of the noble gas mixture (a) to nitrogen is from 3.5 : 1 to 6.5 : 1.

3.  A process for the production of a thin X-ray amorphous aluminum nitride or aluminum silicon nitride layer on a surface as claimed in claim 1 or 2, wherein the process gas contains hydrogen.

4.  A process for the production of a thin X-ray amorphous aluminum nitride or aluminum silicon nitride layer on a surface as claimed in claim 3, wherein the volume ratio (d) of nitrogen to hydrogen is from 2 : 1 to 20 : 1.

5.  A process for the production of a sheet-like, multilayer magneto-optical recording material comprising
    (A) an optically transparent dimensionally stable substrate,
    (B) a thermally alterable recording layer which is composed of a lanthanide/transition metal alloy and
    (C) an aluminum nitride and/or aluminum silicon nitride layer on one or both sides of the recording layer (B),
    in which process
    (i) the individual layers (B) and (C) are applied to the substrate (A) in the desired sequence, number and thickness and with the desired composition in each case via the gas phase,
    (ii) the layer(s) (C) being produced by reactive sputtering or reactive magnetron sputtering of aluminum or of aluminum and silicon under reduced pressure in a process gas atmosphere containing a noble gas and nitrogen, after which
    (iii) a defined magnetization is induced in the recording layer (B), oriented at right angles to its surface,
    wherein, in the production of the layer(s) (C),
    (a) the noble gas used is a mixture of argon and one or more of the noble gases neon, krypton or xenon,
    (b) the volume ratio of argon to the other noble gases being from 2 : 1 to 100 : 1 and
    (c) the volume ratio of the noble gas mixture (a) to nitrogen being from 2 : 1 to 10 : 1.

6.  A process for the production of a sheet-like, multilayer magneto-optical recording material as claimed in claim 5, wherein the volume ratio (c) of the noble gas mixture (a) to nitrogen is from 3.5 : 1 to 6.5 : 1.

7.  A process for the production of a sheet-like, multilayer magneto-optical recording material as claimed in claim 5 or 6, wherein the process gas contains hydrogen.

8.  A process for the production of a sheet-like, multilayer magneto-optical recording material as claimed in claim 7, wherein the volume ratio (d) of nitrogen to hydrogen is from 2 : 1 to 20 : 1.

9.  A process for the production of a sheet-like, multilayer magneto-optical recording material as claimed in any of claims 5 to 8, wherein an oxide layer (C') whose thickness is from 0.2 to 0.8 times the thickness of the layer (C) is produced at least on that layer (C) which faces away from the substrate (A).

10. A process for the production of a sheet-like, multilayer magneto-optical recording material as claimed in claim 15, wherein the thickness of the oxide layer (C') is from 0.25 to 0.75 times the thickness of the

18

layer (C), the oxide used being $Al_2O_3$, $SiO_2$, $SiO$, $PbO$, $Pb_2O_3$, $SnO_2$, $Y_2O_3$, $ZrO_2$, $HfO_2$, $MoO_3$, $Nb_2O_5$, $Ta_2O_5$, $TiO_2$, $ThO_2$ or an oxide which has the elemental composition I

$$(Al_xS_{1-x})_{1-z}(M^1_rM^2_sM^3_t)_z \qquad I$$

where the indices and the variables have the following meanings:

$M^1$, $M^2$ and $M^3$ are each Ti, Zr, Hf, Th, Sc, Y, La, Ce, Pr, Nd, Sm, Eu, Gd, Tb, Dy, Ho, Er, Tm, Yb, Lu, V, Nb, Ta, Cr, Mo, W, Mn, Re, Fe, Co, Rh, Cu, Zn, Ca, Mg, Sr, Ba, B, Ga, In, Tl, Ge, Sn, Pb, P, As, Sb and Te, with the provisos that $M^1$, $M^2$ and $M^3$ differ from one another or that they are identical or different if $M^1$, $M^2$ and $M^3$ are lanthanum or a lanthanide,

x is from 0 to 1,

z is r + s + t,

r and s are each from 0.005 to 0.15 and

t is from 0 to 0.005.

## Revendications

1. Procédé de production d'une mince couche radioamorphe de nitrure d'aluminium ou nitrure d'aluminiumsilicium sur une surface, par vaporisation cathodique réactive ou vaporisation cathodique réactive au magnétron, sous vide, d'aluminium ou d'aluminium et de silicium en atmosphère de gaz réactionnel contenant un gaz rare et de l'azote, et séparation de la couche de nitrure respective d'avec la phase gazeuse, caractérisé par le fait que

   a) l'on utilise, comme gaz rare, un mélange d'argon et d'un ou plusieurs des gaz rares néon, krypton ou xénon,

   b) le rapport des volumes d'argon et des autres gaz rares étant compris entre 2/1 et 100/1 et

   c) le rapport des volumes du mélange de gaz rares (a) et de l'azote étant compris entre 2/1 et 10/1.

2. Procédé de production d'une mince couche radioamorphe de nitrure d'aluminium ou nitrure d'aluminiumsilicium sur une surface, selon la revendication 1, caractérisé par le fait que le rapport des volumes du mélange de gaz rares (a) et de l'azote est entre 3,5/1 et 6,5/1.

3. Procédé de production d'une mince couche radioamorphe de nitrure d'aluminium ou nitrure d'aluminiumsilicium sur une surface, selon l'une des revendications 1 ou 2, caractérisé par le fait que le gaz réactionnel contient de l'hydrogène.

4. Procédé de production d'une mince couche radioamorphe de nitrure d'aluminium ou nitrure d'aluminiumsilicium sur une surface, selon la revendication 3, caractérisé par le fait que le rapport des volumes (d) d'azote et d'hydrogène est compris entre 2/1 et 20/1.

5. Procédé de préparation d'un matériau d'enregistrement magnéto-optique à plusieurs couches planes, comportant

   A) un support optiquement transparent, ayant une stabilité dimensionnelle,

   B) une couche d'enregistrement thermiquement variable, à base d'un alliage de lanthanide-métal de transition, et

   C) une couche de nitrure d'aluminium et/ou d'aluminiumsilicium sur une ou les deux faces de la couche d'enregistrement (B),

   avec lequel

   (i) les différentes couches (B) et (C) sont appliquées sur le support (A) dans l'ordre, en nombre et en l'épaisseur souhaités et avec la composition interne chaque fois voulue, à partir de la phase gazeuse,

   (ii) la (les) couche(s) (C) étant produites par vaporisation cathodique réactive au magnétron d'aluminium ou d'aluminium et de silicium, sous vide, en atmosphère de gaz réactionnel contenant du gaz rare et de l'azote, ensuite

   (iii) une aimantation définie, orientée perpendiculairement à la surface de la couche d'enregistrement (B) est induite dans celle-ci,

   caractérisé par le fait que, lors de la production de(s) couche(s) (C),

   a) on utilise, comme gaz rare, un mélange d'argon et d'un ou plusieurs des gaz rares néon, krypton ou xénon,

EP 0 326 935 B1

b) le rapport des volumes d'argon et des autres gaz rares étant compris entre 2/1 et 100/1 et

c) le rapport des volumes du mélange de gaz rares (a) et de l'azote étant compris entre 2/1 et 10/1.

**6.** Procédé de préparation d'un matériau d'enregistrement magnéto-optique à plusieurs couches planes, selon la revendication 5, caractérisé par le fait que le rapport des volumes (c) du mélange de gaz rares (a) et de l'azote est compris entre 3,5/1 et 6,5/1.

**7.** Procédé de préparation d'un matériau d'enregistrement magnéto-optique à plusieurs couches planes, selon l'une des revendications 5 ou 6, caractérisé par le fait que le gaz réactionnel contient de l'hydrogène.

**8.** Procédé de préparation d'un matériau d'enregistrement magnéto-optique à plusieurs couches planes, selon la revendication 7, caractérisé par le fait que le rapport des volumes (d) d'azote et d'hydrogène est compris entre 2/1 et 20/1.

**9.** Procédé de préparation d'un matériau d'enregistrement magnéto-optique à plusieurs couches planes, selon l'une des revendications 5 à 8, caractérisé par le fait que l'on produit, au moins sur la couche (C) opposée au support (A), une couche d'oxyde (C') dont l'épaisseur représente 0,2 à 0,8 fois l'épaisseur de la couche (C).

**10.** Procédé de préparation d'un matériau d'enregistrement magnéto-optique à plusieurs couches planes, selon la revendication 9, caractérisé par le fait que l'épaisseur de la couche d'oxyde (C') représente 0,25 à 0,75 fois l'épaisseur de la couche (C), en utilisant comme oxyde $Al_2O_3$, $SiO_2$, $SiO$, $PbO$, $Pb_2O_3$, $SnO_2$, $Y_2O_3$, $ZrO_2$, $HfO_2$, $MoO_3$, $Nb_2O_5$, $Ta_2O_5$, $TiO_2$, $ThO_2$ ou un oxyde présentant la composition élémentaire I

$$(Al_xSi_{1-x})_{1-z}(M^1{}_rM^2{}_sM^3{}_t)_z \qquad I,$$

les indices et les variables ayant les significations suivantes :

$M^1$, $M^2$ et $M^3$ : Ti, Zr, Hf, Th, Sc, Y, La, Ce, Pr, Nd, Sm, Eu, Gd, Tb, Dy, Ho, Er, Tm, Yb, Lu, V, Nb, Ta, Cr, Mo, W, Mn, Re, Fe, Co, Rh, Cu, Zn, Ca, Mg, Sr, Ba, B, Ga, In, Tl, Ge, Sn, Pb, P, As, Sb et Te, étant entendu que $M^1$, $M^2$ et $M^3$ sont différents les uns des autres, ou sont identiques ou différents les uns des autres lorsque $M^1$, $M^2$ et $M^3$ représentent lanthane ou lanthanide;

$X = 0$ à 1;

$z = r + s + t$;

$r = 0,005$ à 0,15;

$s = 0,005$ à 0,15;

$t = 0$ à 0,005.